# EUROPEAN PATENT APPLICATION

(11) **EP 3 147 258 A1**
(43) Date of publication of application: **29.03.2017**
(21) Application number: 15186162.2
(22) Date of filing: 22.09.2015
(51) Int. Cl.: B81C 1/00, H05K 3/00, B81B 7/00

(54) **CONNECTION PANEL FOR ELECTRONIC COMPONENTS**

(71) Applicant: AT & S Austria Technologie & Systemtechnik Aktiengesellschaft, 8700 Leoben-Hinterberg (AT)
(72) Inventor: Kasper, Alexander, 8055 Graz (AT); Grabmaier, Sandra, 8720 Knittelfeld (AT); Leitgeb, Markus, 8793 Trofaiach (AT)
(74) Representative: Patentanwaltskanzlei Matschnig & Forsthuber OG

(57) **Abstract**

In a connection panel for electronic components (1) comprising a plurality of insulating layers (8, 9, 2, 11, 12) and conductive layers (13, 14, 15) and further comprising an electronic sensor (4), the sensor (4) is comprised of at least one flexure member (4') formed by a flexure layer (2), the flexure member (4') protruding from the flexure layer (2) and into a clearance (3) within the flexure layer (2) and carrying at least a part of a flexure sensing device (6).

## Description

The invention relates to a connection panel for electronic components comprising a plurality of insulating layers and conductive layers and further comprising an electronic sensor as well as the use thereof.

### Description of the Related Art

The invention relates to connection panels for electronic components in general, wherein electronic components such as transistors, integrated circuits (ICs, microchips) and the like are arranged on or embedded within a panel carrying and electrically connecting those electronic components. Such connection panels can be printed circuit boards (PCBs) or IC-substrates used for connecting a single integrated circuit or a plurality of integrated circuits to a printed circuit board. In fact, IC-substrates and printed circuit boards are highly similar in their basic functionalities and differ merely in size as will be explained and defined at a later stage of this description. For the purposes of this description the terms "printed circuit board", "IC-sub-strate" and "connection panel for electronic components" can be used interchangeably. For the sake of simplicity the following description is mostly directed to printed circuit boards, it is, however, clear the skilled person that the details given in this description may be understood also with reference to IC-substrates.

A component within the sense of the present invention can be any active electronic component or passive component. In particular a component can be a an electronic chip, in particular semiconductor chip, a capacitor, a resistor, an inductance, a data storage such as a DRAM, a filter (high pass filter, low pass filter, band pass filter), a microprocessor, a performance management component, an optoelectronic component, a voltage converter (AC/DC converter, DC/DC converter), an electromechanical transducer (e.g. PZT (lead-zirconate-titanate)-sensor and/or -actor), a transmitter and/or receiver of electromagnetic waves (e.g. an RFID-chip or a transponder), a cryptographic component, a switch (e.g. a transistor-based switch), a microelectromechanical system (MEMS), a battery a camera, an antenna and the like.

Printed circuit boards and IC-substrates, also referred to as printed wiring boards or connection panels for electronic components, are panels carrying and electrically connecting electronic components such as transistors and the like and, hence, form vital parts of electronic devices. Printed circuit boards have a more or less complex structure depending on the specific application. In general, a printed circuit board comprises a plurality of alternately applied conductive layers and insulating layers and the conductive layers are bonded together by hardening panels or plies of glass fibers impregnated with organic resin, said panels forming the insulating layers. Such panels for use in the production of printed circuit boards are widely known in the industry as "prepregs" (preimpregnated fibers), which are delivered and processed in an uncured, hence viscous state of the organic resin. The actual insulating layer results when the organic resin has cured. The insulating layers thus carry the conductive layers, for example formed of copper foil, the conductive layers being appropriately processed to form wirings to electrically connect electronic components. While insulating layers are mostly continuous to provide electric insulation between the conductive layers of the printed circuit board, the conductive layers are usually strongly patterned and open work. Modern printed circuit boards allow for a high degree of integration of electronic components and their appropriate wiring. In the technical field of printed wiring boards, IC-substrates are known to offer similar functionality in terms of alternately applied conductive and insulating layers, however, IC-substrates are much smaller and often serve to connect a microchip to a printed circuit board. To this end, the insulating layers of IC-substrates are often produced of glass or ceramic materials which allows for smaller, high-precision structures.

There is, however, a constant need for further miniaturization in the electronic industry in order to provide consumers and professionals with ever smaller yet more capable electronic devices and installations which require more electronic components to be packaged and wired in a smaller space. Especially mobile electronic devices like smartphones require packaging of a multitude of sensors like accelerometers and pressure sensors on a very limited space to provide the various functionalities sought after by the customer. A lot of such sensors consume considerable space on a printed circuit board and there is, thus, the need to provide such functionalities on a printed circuit board without mounting such components on the surface of a printed circuit board.

### SUMMARY

In order to further increase the degree of integration of sensors such as accelerometers and pressure sensors into a connection panel for electronic components or printed circuit board, the invention is thus directed to a connection panel for electronic components, in which those sensors can be formed by the material of the connection panel for electronic components itself so that such sensors do not have to be mounted to the connection panel for electronic components. Thus, the sensors can be produced on the level of the connection panel for electronic components or printed circuit board by known methods for producing printed circuit boards or connection panels for electronic components. The resulting connection panel for electronic components has an electronic sensor and is particularly highly integrated and cheap in production.

### DETAILED DESCRIPTION

In particular the invention provides for a connection panel for electronic components of the initially mentioned kind which is characterized in that the sensor is comprised of at least one flexure member formed by a flexure layer, the flexure member protruding from the flexure layer and into a clearance within the flexure layer and carrying at least a part of a flexure sensing device. The flexure layer usually is formed by one insulating layer but it can also be comprised of a plurality of insulating layers and conductive layers. For the purposes of this description and the appended claim, the flexure layer is defined as a layer having a clearance to form the flexure member as a part of the flexure layer reaching into the clearance, thus being more prone to flexing, vibrating and/or to being depressed by pressure than the remainder of the flexure layer. The clearance can be a simple cut having a deflection so that the minimum configuration of the flexure member is that of a tongue-shaped area of the flexure layer. By the property of the flexure member to flex, vibrate or to being depressed more easily then the remainder of the flexure layer, the flexure member will react to acceleration of the printed circuit board by flexing in one or another direction. Equally, the flexure member will react upon pressure on one side of the printed circuit board by flexing and naturally the flexure member can be depressed by tactile pressure, for example when the connection panel for electronic components according the present invention is touched for example by the finger of a user. Further according to the present invention, the flexure member carries at least a part of a flexure sensing device which enables to gather data from the flexing of the flexure member due to the above described influences the inventive connection panel for electronic components may be subjected to. As will be described later, the flexure member can carry basically all components of a corresponding flexure sensing device, however, it is also conceivable that only part of a flexure sensing device is arranged on the flexure member in case the flexure sensing device requires elements on the flexure member and on neighboring elements of the connection panel for electronic component. In both cases the flexure sensing device will allow for the movement of the flexure member to be measured and translated into data that can be processed by a micro computer which can for example be arranged on the inventive connection panel for electronic components in the form of a microchip. Thus the present invention allows for the production of highly integrated and cheap acceleration sensors and/or pressure sensors. Since the flexure member is formed from the flexure layer which is a vital part of the inventive printed circuit board and, as stated above, is most likely an insulating layer that is present anyway in the inventive connection panel for electronic components, the production of acceleration and/or pressure sensors becomes very easy and can be integrated in an automated production process of printed circuit boards or the like and can thus be carried out on the level of the printed circuit board itself without having to provide for electronic components that have to be mounted to the printed circuit board.

While it has already been described that the flexure member may take the form of a tongue arranged within a clearance of the flexure layer it is preferred that the configuration of the flexure member be more refined in order to allow for more sensitive flexing of the flexure member than a tongue being more or less rigidly connected to the flexure layer could ever provide. The present invention therefore preferably is devised such that the flexure member is suspended in the clearance by at least one supporting arm. Departing from a simple cut with a deflection that will yield a rounded or cornered tongue protruding from the flexure layer, the clearance in this preferred embodiment will take the form of a rectangular or rounded hole in the flexure layer into which an arm will reach, the arm carrying the main part of the flexure member. The flexure member will thus appear like a peninsula within the flexure layer. The supporting arm offers considerably less rigidity and the flexure member will thus vibrate or flex more easily making the inventive connection panel for electronic components a more capable acceleration sensor and/or pressure sensor.

While the supporting arm of the just described preferred embodiment of the present invention offers the advantage of very reduced stability of the flexure member and thus high sensitivity of the sensor, the provision of only one supporting arm will not allow for precise determination of the direction of an acceleration force or a pressure force. To overcome this, the invention may be devised such that the flexure member is suspended in the clearance by a plurality of supporting arms, preferably by two supporting arms, more preferably by three supporting arms and most preferably by four supporting arms as it is in conformity with a preferred embodiment of the present invention. When the pressure member is supported by four arms within the clearance in the flexure layer it becomes feasible to arrange flexure sensing devices on each of the supporting arms, so that deflections in all directions can be measured independently from each other thus offering the possibility to gather directional data of the acceleration and/or pressure forces the inventive connection panel for electronic components is subjected to.

Preferably the at least one supporting arm is deflected. A deflected form of the at least one supporting arm of the flexure member will make it possible to arrange a longer supporting arm within a clearance within the flexure layer of a defined size, so that the supporting arm becomes even more unstable thus offering additional sensitivity to the sensor and to the inventive connection panel for electronic components.

A preferred embodiment of the present invention is achieved when the flexure sensing device is formed by at least one piezo-element arranged on the at least one supporting arm. Applying piezo-technology allows for highly sensitive, precise and yet cheap sensing devices and this technology can very easily be employed on the level of producing the printed circuit board according to the present invention as will later be explained in more detail.

For example it can be provided for the flexure sensing device to be formed by at least one piezo-element arranged on each of the supporting arms as it is in conformity with a preferred embodiment of the present invention. A piezo-element for use in the context of the present invention can be very small in size and will thus be adapted to be arranged on a supporting arm as previously defined.

For example it can be done with forming a piezo-element by a layer of a piezo-material contacted by wirings. Piezo-materials can be printed or sputtered onto the flexure layer, the flexure layer, as already described, being for example a regular insulating layer of for example FR4-prepreg material and can thus be applied to the flexure member by methods well known to the person skilled in the art of producing printed circuit boards or connection panel for electronic components in general. The contacting of the layer of piezo-material by wirings is of course also within the skill in the art.

According to a preferred embodiment the piezo-material is comprised of a material chosen from the group comprised of piezoactive polymers and rubbers, in particular solvene^{®} EAP, Pyzoflex^{®}, piezoactive glasses, ceramics, ZnO and AlN. Solvene^{®} EAP is a trademark of Solvay International Chemical Group.

While the use of the piezo-technology for forming the flexure sensing devices of the present invention of the present invention is very convenient, it can for certain application nonetheless be preferred that the flexure sensing device is formed by a plurality of resistors individually arranged on the at least one supporting arm, preferably being part of a Wheatstone-bridge. The resistors will change their resistance as a function of flexing or vibrating of the flexure member as the resistors become lengthened and/or jolted. The change in resistance can be computed as acceleration- and(or pressure data.

The resistors can be formed of carbon tracks, which will be lengthened and/or jolted as described above.

Another way to measure the flexing and vibrating of the flexure member is by using electro dynamic measurement. In this preferred embodiment of the present invention the sensing device is formed by an electromagnetic coil and a magnet, one of which being arranged on the flexure member and the other being arranged on the flexure layer at least in an area of the flexure layer surrounding the flexure member to form an electrodynamic sensor. In this embodiment a magnet can be arranged on the flexure member and it will be surrounded by the coil which is arranged in the area of the flexure layer surrounding the flexure member. Hence, when the flexure member flexes or vibrates the magnet will be moved relative to the electromagnetic coil thus inducing a current that can, in turn, be measured and interpreted as acceleration and/or pressure data.

In principle, it is possible to have the flexure member communicate with the surrounding of the inventive connection panel for electronic components, when the flexure layer is not covered and the flexure member within the flexure layer will thus be directly accessible. A more rugged and thus preferred embodiment of the present invention, however, is achieved when the flexure layer is covered by at least one cover layer at least in the area of the flexure member. In this embodiment, the flexure member and hence the flexure sensing device is better protected and will thus provide for more rugged electronic devices using the inventive connection panel for electronic components.

In order to ensure that the flexure member is allowed to move freely in every direction, the invention preferably is conceived in such a way that a cavity is provided between the flexure member and the at least one cover layer.

The cavity can be realized by a reduced thickness of the flexure layer and/or the at least one cover layer in the region of the flexure member or it can be realized in that the cavity is formed by a clearance within an insulating layer arranged between the flexure layer and the cover layer as it is in conformity with a preferred embodiment of the present invention. It is again noted that the various layers as defined within this description, namely the flexure layer, the at least one cover layer and insulating layers can all be of the same kind and can in particular be insulating layers formed of one or more layers of fabric of for example FR4-prepreg material. For the purpose of this description, however, the flexure layer is defined as the layer having the clearance to form the flexure member, the cover layer is a layer covering the flexure member within the flexure layer and insulating layers are layers providing insulation to electric current and being not layers of the group comprised of the flexure layer and cover layer. Also as already stated, the flexure layer can be comprised of a plurality of insulating and even conductive layers and when this is the case the flexure layer is defined as the group of singular layers having the clearance into which the flexure member is protruding. Providing a cavity between the flexure member and the at least one cover layer is definitely more easily to be achieved by the lastly described preferred embodiment of the present invention in which the cavity is formed by a clearance within an insulating layer arranged between flexure layer and the cover layer, as compared to the embodiment in which the thickness of the flexure layer and/or the cover layer in the region of the flexure member is reduced.

The provision of a cavity between the flexure member and the at least one cover layer opens the possibility to use a further kind of flexure sensing device. In this context it is preferred when the flexure sensing device is formed by at least one capacitor having its electrodes on the flexure member and the cover layer. Upon flexing and/or vibrating of the flexure member the clearance between the electrodes arranged on the flexure member and on the cover layer will change, thus altering the capacitance of the capacitors formed by the electrodes arranged on the flexure member and the cover layer which can be interpreted as acceleration and/or pressure changes.

The sensitivity of the inventive connection panel for electronic components to acceleration and/or pressure can considerable be increased when the flexure member carries a weight member adapted to increase flexure of the flexure member. As opposed to an electronic component present on or embedded within the printed circuit board, the weight member as defined by the present claims and description is a passive element such as a simple metal plate or the like. A weight member arranged on the flexure member will increase the flexing movement of the flexure member upon acceleration of the inventive connection panel for electronic components and will thus lead to a higher signal strength of the flexure sensing devices.

An interesting application of the arrangement of a weight member on the flexure member can be put into practice when the weight member is formed by a receptor adapted to bind to at least one chemical and/or biological substance. Such receptors are known to the person skilled in the art of biosensors and chemical sensors and, of course, these receptors change weight when the respective substance for which they are sensitive binds. Thus the weight member of the inventive connection panel for electronic components becomes heavier as the corresponding substance binds to it and the flexure and/or vibrating properties of the flexure member are thereby changed. This can be interpreted as the presence of the corresponding substance and/or the change of the concentration of the substance in the surrounding of the inventive connection panel for electronic components.

It has already previously been described that the flexure layer, the at least one cover layer and the insulating layers of the inventive connection panel for electronic components can all be made of the same material and that the distinction between these three kinds of layers is made to be able to properly define the present invention and does not necessarily mean that these layers are made from different materials. Thus the flexure layer, the at least one cover layer and/or the at least one insulating layer are preferably are made from a material chosen from the group comprised of reinforced or non reinforced resins such as epoxy resin and prepreg-material (e.g. FR-4, FR-5), teflon®, polyamide, polyimide, esters of cyanate, bismaleimide-triazine resin, glasses, glass-like carrier-materials (e.g. multilayer-glass), reinforcing carrier materials, ceramics and metal oxides, high-frequency material and metal foils, for example of Cu or Al. High-frequency materials are materials such as polytetrafluoroethylene, liquid crystal polymer or cyanate ester resins.

According to a preferred embodiment of the present invention, the connection panel for electronic components comprises at least one embedded component.

In the following the invention will be described in more detail by way of an exemplary embodiment shown in the drawing. In the drawing
- Fig. 1 shows a plan view of the inventive connection panel for electronic components without a cover layer,
- Fig. 2 shows a sectional view of the inventive connection panel for electronic components having a cover layer,
- Fig. 3 shows four plan views of flexure members in accordance with the present invention, and
- Fig. 4 shows a variety of flexure members in accordance with the present invention having different arrangements of supporting arms.

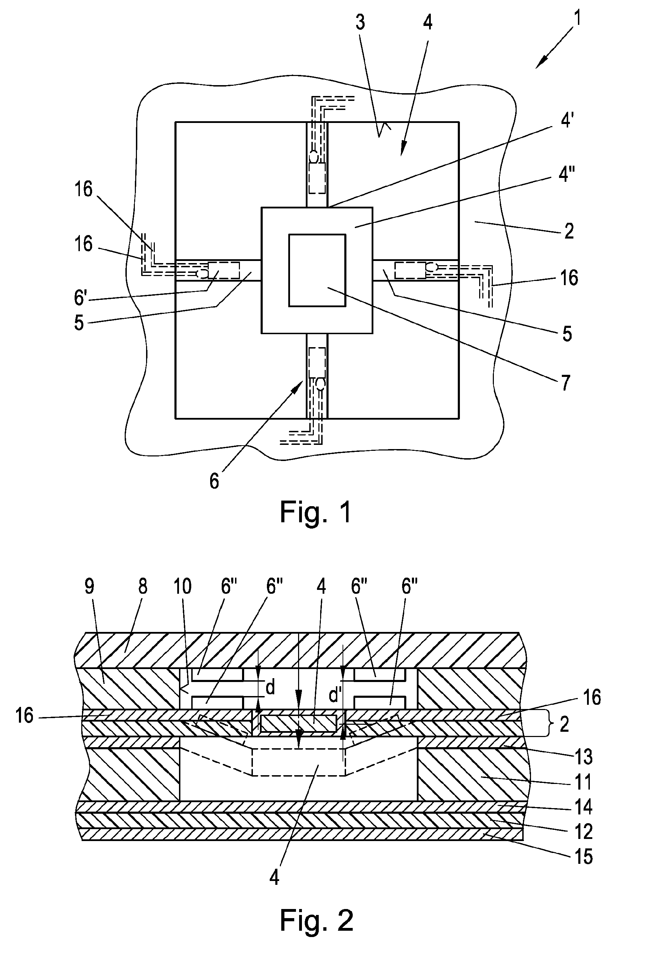

In Fig. 1 the inventive connection panel for electronic components is denoted by reference numeral 1. The connection panel for electronic components 1 can be printed circuit board or

IC-substrate or the like. The connection panel for electronic components 1 has a flexure layer 2, for example formed of FR4-prepreg material. The flexure layer 2 has a clearance 3 to form a sensor 4 comprised of a flexure member 4' which protrudes from the flexure layer 2 into the clearance 3 within the flexure layer 2. The flexure member 4' is comprised of a main part 4" and supporting arms 5 which allow for a comparatively high flexibility of the flexure member 4' as compared to the remainder of the flexure layer 2, so that the flexure member 4' can flex and/or vibrate rather freely within the clearance 3 of the flexure layer 2. The flexure member 4' carries at least a part of a flexure sensing device 6, in this case the flexure member 4' carries four piezo-elements 6' which piezo-elements form the entire flexure sensing devices 6 on the supporting arms 5. As previously described, the flexure sensing devices 6 can also be comprised of resistors, which in an alternative embodiment would be arranged on the supporting arms 5 instead of the piezo-elements 6'In this embodiment, the flexure member 4' furthermore carries a weight member 7 which can be simple metal plate or other plate of relatively high density or it can be a receptor adapted to bind to a chemical and/or biological substance thereby altering its weight and thus altering the flexing and/or vibrating properties of the flexure member 4. The piezo-elements 6' are formed of a layer of piezo-paste and appropriate wirings 16.

In the sectional view of Fig. 2 the flexure member 4' carries electrodes 6" which form capacitors with corresponding electrodes 6" on a cover layer 8 which is spaced from the flexure layer 2 by an insulating layer 9 having a cavity 10 to allow for free flexing and/or vibrating of the flexure member 4. In Fig. 2, a flexed position of the flexure member 4' is drawn in dashed lines and it is apparent that the distance d between corresponding electrodes 6" in the flexed position of the flexure member 4' is altered to a different distance d' which of course results in a different capacitance of the capacitor formed by the corresponding electrodes 6" which in turn can be interpreted as flexing and/or vibrating of the flexure member 4' thus giving information on acceleration and/or pressure exerted on the connection panel for electronic components of the present invention. Also in Fig. 2 it can be seen that the inventive connection panel for electronic components 1 comprises a plurality of insulating layers 8, 9, 2,11 and 12 as well as a plurality of conductive layers 13,14 and 15.

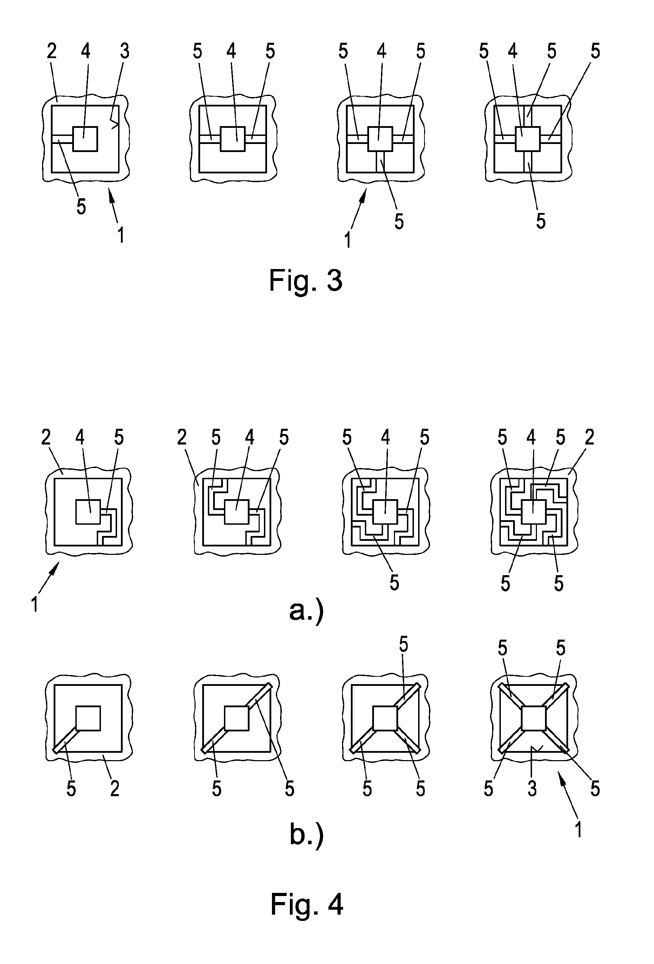

In Fig. 3 it is shown that the flexure member 4' can be suspended within the clearance 3 within the flexure layer 2 on one supporting arm 5 only. However, configurations with two, three, four and of course even more supporting arms 5 for the flexure member 4' are conceivable without departing from the spirit of the present invention.

As shown in Fig. 4 the supporting arm 5 or the supporting arms 5 can be deflected and also here configurations with one, two or three or even more arms are thinkable. In Fig. 4b it is shown that the supporting arm 5 can also protrude from corners of the clearance 3 within the flexure layer 2 of the inventive connection panel for electronic components 1.

## Claims

1. Connection panel for electronic components (1) comprising a plurality of insulating layers (8,9,2,11,12) and conductive layers (13,14,15) and further comprising an electronic sensor (4), **characterized in that** the sensor (4) is comprised of at least one flexure member (4') formed by a flexure layer (2), the flexure member (4') protruding from the flexure layer (2) and into a clearance (3) within the flexure layer (2) and carrying at least a part of a flexure sensing device (6).

2. Connection panel for electronic components according to claim 1, **characterized in that** the flexure member (4') is suspended in the clearance (3) by at least one supporting arm (5).

3. Connection panel for electronic components according to claims 1 or 2, **characterized in that** the flexure member (4') is suspended in the clearance (3) by a plurality of supporting arms (5), preferably by two supporting arms, more preferably by three supporting arms (5) and most preferably by four supporting arms (5).

4. Connection panel for electronic components according to one of claims 1 to 3, **characterized in that** the at least one supporting arm (5) is deflected.

5. Connection panel for electronic components according to one of claims 1 to 4, **characterized in that** the flexure sensing device (6) is formed by at least one piezo-element (6') arranged on the at least one supporting arm (5).

6. Connection panel for electronic components according to claim 5, **characterized in that** the flexure sensing device (6) is formed by at least one piezo-element (6') arranged on each of the supporting arms (5).

7. Connection panel for electronic components according to claim 5 or 6, **characterized in that** a piezo-element (6') is formed by a layer of a piezo-material contacted by wirings (16).

8. Connection panel for electronic components according to one of claims 5 to 7, **characterized in that** the piezo-material is comprised of a material chosen from the group comprised of piezoactive polymers and rubbers, in particular solvene^{®} EAP, Pyzoflex^{®}, piezoactive glasses, ceramics, ZnO and AlN.

9. Connection panel for electronic components according to one of claims 1 to 4, **characterized in that** the flexure sensing device (6) is formed by a plurality of resistors individually arranged on the at least one supporting arm (5), preferably being part of a Wheatstone-bridge.

10. Connection panel for electronic components according to one of claims 1 to 4, **characterized in that** the sensing device (6) is formed by an electromagnetic coil and a magnet, one of which being arranged on the flexure member (4') and the other being arranged on the flexure layer (2) at least in an area of the flexure layer (2) surrounding the flexure member (4') to form an electrodynamic sensor.

11. Connection panel for electronic components according to one of claims 1 to 10, **characterized in that** the flexure layer (2) is covered by at least one cover layer (8) at least in the area of the flexure member (4).

12. Connection panel for electronic components according to claim 11, **characterized in that** a cavity (10) is provided between the flexure member (4') and the at least one cover layer (8).

13. Connection panel for electronic components according to claim 11 or 12, **characterized in that** the cavity (10) is formed by a clearance within an insulating layer (9) arranged between the flexure layer (2) and the cover layer (8).

14. Connection panel for electronic components according to claim 12 or 13, **characterized in that** the flexure sensing device (6) is formed by at least one capacitor having its electrodes (6") on the flexure member (4') and the cover layer (8).

15. Connection panel for electronic components according to one of claims 1 to 14, **characterized in that** the connection panel for electronic components (1) comprises at least one embedded component.
